# EUROPEAN PATENT APPLICATION

(11) **EP 4 761 544 A1**
(43) Date of publication of application: **17.06.2026**
(21) Application number: 25203400.4
(22) Date of filing: 19.09.2025
(51) Int. Cl.: H10K 59/38, H10K 59/80

(54) **LIGHT EMITTING DISPLAY DEVICE**

(30) Priority: 11.12.2024 KR 20240183773
(71) Applicant: LG Display Co., Ltd., Seoul, 07336 (KR)
(72) Inventor: PARK, Jae-Hyun, 10845 Gyeonggi-do (KR); JUNG, Dong-Ryul, 10845 Gyeonggi-do (KR); YANG, Ji-Seok, 10845 Gyeonggi-do (KR); PARK, Je-Beom, 10845 Gyeonggi-do (KR)
(74) Representative: Ter Meer Steinmeister & Partner

(57) **Abstract**

A light emitting display device can include a plurality of lower uneven patterns on a surface of an insulating layer corresponding to a non-emission area and a plurality of upper uneven patterns on a surface of a black matrix. The light emitting display device can further include a light control uneven pattern on a surface of the insulating layer corresponding to an emission area. The shapes of the lower uneven pattern and/or the upper uneven pattern can be changed according to a subpixel region.

## Description

This application claims priority to Korean Patent Application No. 10-2024-0183773, filed in the Republic of Korea on December 11, 2024.

### TECHNICAL FIELD

The disclosure relates to a light emitting display device.

### BACKGROUND

As large surface area display devices have been developed, the needs for flat surface display devices with small occupation area have been increased. Technologies for a light emitting display device including a light emitting diode as one of the flat surface display devices have been developed rapidly. Light emitting display devices can be classified to an organic light emitting display devices, which use organic luminescent materials, and an inorganic light emitting display devices, which use inorganic luminescent materials.

### SUMMARY

It is an object of the invention to reduce stains caused by external light reflection with maintaining luminance and/or to emit light with uniform intensity to each sub-pixel region.

The object is solved by the features of the independent claims. Preferred embodiments are given in the dependent claims.

In one aspect, a light emitting display device is provided that includes a substrate defining an emission area and a non-emission area; a light emitting diode disposed on the substrate correspondingly to the emission area; a bank layer disposed at an outside of the light emitting diode correspondingly to the non-emission area; an insulating layer disposed on the light emitting diode and the bank layer; a color control pattern disposed on the insulating layer correspondingly to the emission area; and a black matrix disposed on the insulating layer correspondingly to the non-emission area, wherein the insulating layer includes a plurality of lower uneven patterns on a surface of the insulating layer corresponding to the non-emission area, wherein the black matrix includes a plurality of upper uneven patterns on a surface of the black matrix, and wherein each of the plurality lower uneven patterns and the plurality of upper uneven patterns has a corrugated structure.

In some implementations, the color control pattern can have a refractive index greater than a refractive index of the insulating layer.

For example, the color control pattern can have a refractive index greater than a refractive index of the insulating layer by 0.07 to 0.2.

An angle between a peak and a valley in the plurality of lower uneven patterns and the plurality of upper uneven patterns can be 15° or more and 60° or less.

In some implementations, the peak of the plurality of lower uneven patterns can be arranged to deviate from the peak of the plurality of upper uneven patterns.

As an example, the valley of the plurality of lower uneven patterns can be arranged to correspond to the peak of the plurality of upper uneven patterns, and the peak of the plurality of lower uneven patterns can be arranged to correspond to the valley of the plurality of upper uneven patterns.

A side surface of the bank layer can be disposed to extend further toward the emission area than a side surface of the black matrix.

At least one of the plurality of lower uneven patterns and the plurality of upper uneven patterns can extend to a peripheral area of the color control pattern.

In some implementations, the light emitting display device can further comprise a plurality of light control uneven patterns formed on the surface of the insulating layer corresponding to the emission area.

In some implementations, an average pitch between a peak and an adjacent peak in the plurality of lower uneven patterns can be smaller than an average pitch between a peak and an adjacent peak in the plurality of light control uneven patterns.

In some implementations, the substrate can comprise a first sub-pixel region and a second sub-pixel region, the color control pattern can comprise a first color control pattern disposed correspondingly to the emission area in the first sub-pixel region; and a second color control pattern disposed correspondingly to the emission area in the second sub-pixel region.

The black matrix can comprise a first black matrix disposed correspondingly to the non-emission area in the first sub-pixel region; and a second black matrix disposed correspondingly to the non-emission area in the second sub-pixel region.

For example, the plurality of lower uneven patterns can comprise a plurality of first lower uneven patterns formed on the surface of the insulating layer corresponding to the non-emission area in the first sub-pixel region; and a plurality of second lower uneven patterns formed on the surface of the insulating layer corresponding to the non-emission area in the second sub-pixel region.

The plurality of upper uneven patterns can comprise a plurality of first upper uneven patterns formed on a surface of the first black matrix; and a plurality of second upper uneven patterns formed on a surface of the second black matrix.

Each of the plurality of first lower uneven patterns and the plurality of first upper uneven patterns can extend to a peripheral area of the first color control pattern, and each of the plurality of second lower uneven patterns and the plurality of second upper uneven patterns can extend to a peripheral area of the second color control pattern.

In some implementations, the light emitting display device can further comprise a plurality of first light control uneven patterns formed on the surface of the insulating layer corresponding to the emission area in the first sub-pixel region; and a plurality of second light control uneven patterns formed on the surface of the insulating layer corresponding to the emission area in the second sub-pixel region.

An extension length of the plurality of first lower uneven patterns and the plurality of first upper uneven patterns to the peripheral area of the first color control pattern can be longer than an extension length of the plurality of second lower uneven patterns and the plurality of second upper uneven patterns to the peripheral area of the second color control pattern.

The first sub-pixel region can comprise a green sub-pixel and the second sub-pixel region can comprise a blue sub-pixel or a red sub-pixel.

In some implementations, the substrate can further comprise a third sub-pixel region, the color control pattern can further comprise a third color control pattern disposed correspondingly to the emission area in the third sub-pixel region.

The black matrix can further comprise a third black matrix disposed correspondingly to the non-emission area in the third sub-pixel region.

The plurality of lower uneven patterns can comprise a plurality of first lower uneven patterns formed on the surface of the insulating layer corresponding to the non-emission area in the first sub-pixel region; a plurality of second lower uneven patterns formed on the surface of the insulating layer corresponding to the non-emission area in the second sub-pixel region; and a plurality of third lower uneven patterns formed on the surface of the insulating layer corresponding to the non-emission area in the third sub-pixel region.

The plurality of upper uneven patterns can comprise a plurality of first upper uneven patterns formed on a surface of the first black matrix; a plurality of second upper uneven patterns formed on a surface of the second black matrix; and a plurality of third upper uneven patterns formed on a surface of the third black matrix.

Each of the plurality of first lower uneven patterns and the plurality of first upper uneven patterns can extend to a peripheral area of the first color control pattern, each of the plurality of second lower uneven patterns and the plurality of second upper uneven patterns can extend to a peripheral area of the second color control pattern,

Each of the plurality of third lower uneven patterns and the plurality of third upper uneven patterns can extend to a peripheral area of the third color control pattern.

The light emitting display device can further comprise a plurality of first light control uneven patterns formed on the surface of the insulating layer corresponding to the emission area in the first sub-pixel region; a plurality of second light control uneven patterns formed on the surface of the insulating layer corresponding to the emission area in the second sub-pixel region; and a plurality of third light control uneven patterns formed on the surface of the insulating layer corresponding to the emission area in the third sub-pixel region.

An extension length of the plurality of first lower uneven patterns and the plurality of first upper uneven patterns to the peripheral area of the first color control pattern can be longer than an extension length of the plurality of second lower uneven patterns and the plurality of second upper uneven patterns to the peripheral area of the second color control pattern and an extension length of the plurality of third lower uneven patterns and the plurality of third upper uneven patterns to the peripheral area of the third color control pattern.

The first sub-pixel region can comprise a green sub-pixel, the second sub-pixel region can comprise a red sub-pixel and the third sub-pixel region can comprise a blue sub-pixel.

A voltage applied to the first sub-pixel region can be greater than a voltage applied to each of the second sub-pixel region and the third sub-pixel region.

In some implementations, the light emitting display device can comprise the plurality of lower uneven patterns positioned on the surface of the insulating layer corresponding to the non-emission area and the plurality of upper uneven patterns positioned on the surface of the black matrix. The plurality of uneven patterns can be configured so as to reduce external light reflection and to reduce or prevent stains, such as rainbow mura.

Alternatively or additionally, the light emitting display device can further comprise the plural light control uneven patterns positioned on the surface of the insulating layer corresponding to the emission area.

In addition, the plurality of lower uneven patterns and/or the plurality of upper uneven patterns can be further extended around the color control pattern disposed in the sub-pixel region having a relatively long luminescence lifespan in the light emitting display device. The amount of light and/or the intensity of light emitted from each sub-pixel region can be matched by relatively increasing the voltage applied in the sub-pixel region having a relatively long luminescence lifespan compared to other sub-pixel regions. Accordingly, light of uniform intensity can be emitted from each sub-pixel region, which can increase a display quality of the light emitting display device.

The technology described in this specification can be implemented so as to realize one or more of the following advantages.

In general, light emitting display devices do not require polarizers. However, external light reflection can lower display quality for light emitting display devices without polarizers.

A light emitting display device can include a polarizer in a display surface to reduce such external light reflection. While a polarizer can reduce external light reflection in a light emitting display device, the polarizer can also reduce a luminance of the light emitting display.

Accordingly, implementations of the disclosure can provide a light emitting display device that substantially obviates one or more of the problems due to the limitations and disadvantages of the related art.

Implementations of the disclosure can provide a light emitting display device that can reduce stains caused by external light reflection with maintaining luminance.

Implementations of the disclosure can provide a light emitting display device that can emit light with uniform intensity to each sub-pixel region.

By not requiring a separate polarizer, implementations of the disclosure can provide a light emitting display device capable of lower power driving by reducing or preventing external light refection without lowering luminance.

It is to be understood that both the foregoing general description and the following detailed description are exemplary and explanatory, and are intended to provide further explanation of the inventive concepts as claimed. Additional features and aspects will be set forth in the description that follows, and in part will be apparent from the description, or can be learned by practice of the disclosed concepts provided herein. Other features and aspects of the disclosed concept can be realized and attained by the structure particularly pointed out in the written description, or derivable therefrom, and the claims hereof as well as the appended drawings.

### BRIEF DESCRIPTION OF THE DRAWINGS

The accompanying drawings, which provide a further understanding of the disclosure, are incorporated in and constitute a part of this application, illustrate implementations of the disclosure and together with the description serve to explain principles of the disclosure.
FIG.1 is a schematic circuit diagram of a light emitting display device in one or more implementations.
FIG.2 is a schematic cross-sectional view of the light emitting display device in a first implementation.
FIG. 3 illustrates a schematic cross-sectional view of an uneven patterns structure in accordance with the first implementation of the disclosure.
FIG. 4 illustrates a schematic cross-sectional view of the peaks and valleys in the uneven patterns in accordance with the first implementation of the disclosure.
FIG. 5 illustrates a schematic cross-sectional view of a light emitting display device in accordance with a second implementation of the disclosure.
FIG. 6 illustrates a schematic cross-sectional view of an uneven patterns structure in accordance with the second implementation of the disclosure.
FIG. 7 is a schematic plane view of a photomask arrangement located in an emission area and a non-emission area for forming uneven patterns in accordance with an exemplary implementation.
FIGS. 8A to 8E illustrates a schematic cross-sectional view of a process of forming the plurality of uneven patterns on the insulating layer and the black matrix in accordance with the second implementation of the disclosure.
FIG. 9 illustrates a schematic cross-sectional view of which external light reflection is controlled by the plurality of uneven patterns in accordance with the second implementation of the disclosure.
FIG. 10 illustrates a schematic cross-sectional view of a light emitting display device in accordance with a third implementation of the disclosure.
FIG. 11 illustrates a schematic cross-sectional view of an extension structure of the uneven patterns in a first sub-pixel region in accordance with the third implementation of the disclosure.
FIG. 12 illustrates a schematic cross-sectional view of an extension structure of the uneven patterns in a second sub-pixel region and/or a third sub-pixel region in accordance with the third implementation of the disclosure.
FIG. 13 illustrates a schematic cross-sectional view of a light emitting display device in accordance with a fourth implementation of the disclosure.
FIG. 14 is a photograph that illustrates a photomask arrangement applied to form the plurality of uneven patterns in an exemplary Example of the disclosure.
FIG. 15 is a graph that measure a cross-sectional profile of corrugated uneven patterns arranged in accordance with the photolithography process in an exemplary Example of the disclosure.
FIG. 16 is a photograph that illustrates a corrugated or irregular-shaped lower uneven patterns disposed on the surface of the insulating layer in an exemplary Example of the disclosure.
FIG. 17 photograph illustrate a stain in a light emitting display device without the uneven patterns.
FIG. 18 is a photograph that illustrates a stain is removed in the light emitting display device with the uneven patterns.
FIGS. 19 and 20 are graphs that measure an external light reflection in the light emitting display device without the uneven patterns and the light emitting display device with the uneven patterns.
FIG. 21 graph that measures an external light reflection in accordance with Pull back length which is a spaced-apart distance between the side of the lower uneven patterns extended to the emission area and the side of the bank layer of the boundary between the emission areas in an Example.
FIG. 22 is a schematic plane view of a structure of the first sub-pixel region, the second sub-pixel region and the third sub-pixel region in accordance with an exemplary Example of the disclosure.

### DETAILED DESCRIPTION

Shapes, sizes, ratios, angles, numbers, and the like disclosed in the drawings for describing implementations of the disclosure are merely illustrative examples, and thus the disclosure is not limited to the illustrated examples. The same reference numerals refer to the same components throughout this disclosure unless otherwise specified. Further, in the following description of the disclosure, where a detailed description of a known related art can unnecessarily obscure the gist of the disclosure, the detailed description thereof can be omitted herein or can be briefly discussed.

Where terms such as "including," "having," "comprising," and the like are used in this disclosure, other parts can be added unless a more limiting term like "only" is used herein. Further, where a component is expressed as being singular, being plural is included, and vice versa, unless otherwise specified.

In analyzing a component, an error range should be interpreted as being included even where there is no explicit description.

In describing a positional relationship, for example, where a positional relationship of two parts/layers is described as being "over," "on," "above," "below," "under," "next to," or the like, one or more other parts/layers can be provided between the two parts/layers, unless a more limiting term like "immediately" or "directly" is used therewith.

When a component or layer is referred to as being "on" another component or layer, it includes both instances where the other component is directly on the other component or layer, or where there is another layer or component intervening therebetween.

In describing a temporal relationship, for example, where a temporal predecessor relationship is described as being "after," "subsequent," "next to," "prior to," or the like, unless a more limiting term like "immediately" or "directly" is used, cases that are not continuous or sequential can also be included. Further, the term "can" fully encompasses all the meanings and coverages of the term "may" and vice versa.

Although the terms first, second, and the like can be used to describe various components, these components are not substantially limited by these terms. These terms are used only to refer to one component separately from another component, and may not define any particular order or sequence. Therefore, a first component described below can substantially be a second component, and vice versa, within the technical concept of the disclosure.

Features of various implementations of the disclosure can be partially or entirely united or combined with each other, technically various interlocking and driving are possible, and each of the implementations can be independently implemented with respect to each other or implemented together in a co-dependent relationship.

All the components of each display device of all implementations of the disclosure are operatively coupled and configured.

Reference will now be made in detail to aspects of the disclosure, examples of which are illustrated in the accompanying drawings. Wherever possible, the same reference numbers will be used throughout the drawings to refer to the same or like parts.

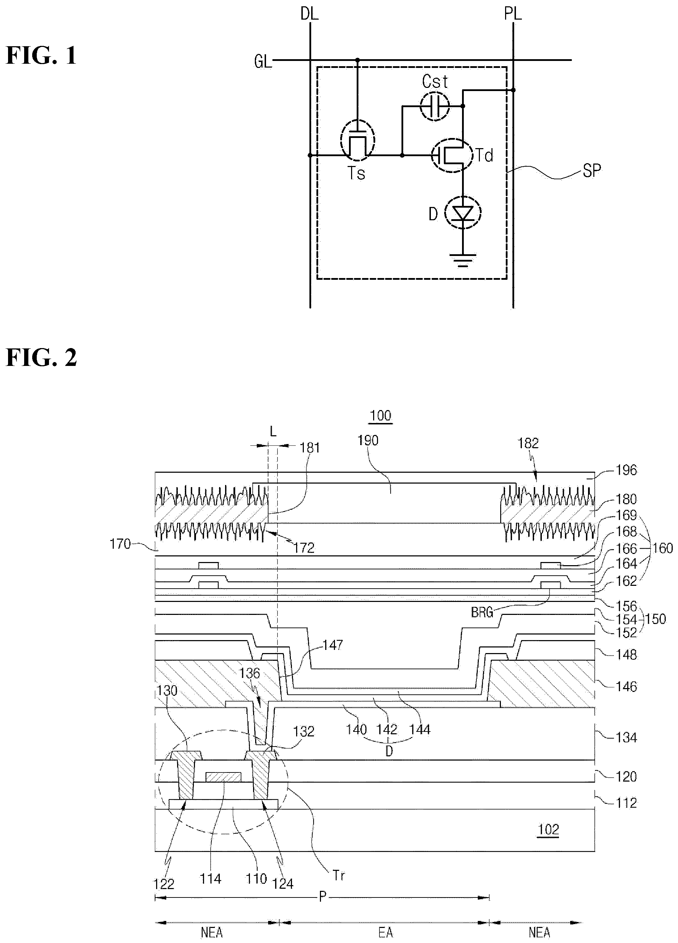

FIG. 1 illustrates a schematic circuit diagram of a light emitting display device in one or more implementations of the disclosure.

Referring to FIG. 1, the display device includes a gate line GL, a data line DL and a power line PL crossing each other to define a sub-pixel region SP. A switching thin film transistor Ts, a driving thin film transistor Td, a storage capacitor Cst and a light-emitting diode D can be disposed in the sub-pixel region SP. A pixel region including a plurality of sub-pixel regions SPs is defined in the light emitting display device. As an example, the sub-pixel region SP can include, but is not limited to, a red (R) sub-pixel, a green (G) sub-pixel and a blue (B) sub-pixel.

The switching thin film transistor Ts is connected to the gate line GL and the data line DL. The driving thin film transistor Td and the storage capacitor Cst are connected between the switching thin film transistor Ts and the power line PL, and the light emitting diode D is connected to the driving thin film transistor Td.

In the display device, when the switching thin film transistor Ts is turned on by a gate signal applied to the gate line GL, a data signal applied to the data line DL is applied to gate electrode 114 (FIG. 2) and one electrode of the storage capacitor Cst through the switching thin film transistor Ts.

The driving thin film transistor Td is turned on by the data signal applied to the gate electrode 114 so that a current proportional to the data signal is supplied from the power line PL to the light-emitting diode D through the driving thin film transistor Td. And then, the light- emitting diode D emits light having a luminance proportional to the current flowing through the driving thin film transistor Td. In this case, the storage capacitor Cst is charged with a voltage proportional to the data signal so that the voltage of the gate electrode 114 in the driving thin film transistor Td is kept constant during one frame. Therefore, the display device can display a desired image.

FIG. 2 illustrates a schematic cross-sectional view of the light emitting display device in a first implementation of the disclosure.

Referring to FIG. 2, a light emitting display device 100 can include a substrate 102, a thin film transistor Tr disposed on the substrate 102, and a light emitting diode D disposed on the substrate 102 and connected to the thin film transistor Tr. In addition, the light emitting display device 100 can further comprise a bank layer 146 disposed adjacently to the light emitting diode D, an insulating layer 170 covering the light emitting diode D and the bank layer 146, and a black matrix 180 and a color control pattern 190 disposed on the insulating layer 170.

The sub-pixel region SP can include the plurality of sub-pixels. For example, the sub-pixel region SP can include the red (R) sub-pixel, the green (G) sub-pixel and the blue (B) sub-pixel. Alternatively or additionally, the sub-pixel region SP can include a white (W) sub-pixel. Each of the sub-pixel regions SPs can comprise an emission area EA and a non-emission area NEA disposed adjacently to the emission area EA or around the emission area EA.

The substrate 102 can comprise, but is not limited to, a glass substrate, a flexible substrate or a polymer plastics substrate. For example, the substrate 102 can be configured as at least one of a polyimide (PI) substrate, a polyether sulfone (PES) substrate, a polyethylene naphthalate (PEN) substrate, a polyethylene terephthalate (PET) substrate and a polycarbonate (PC) substrate.

The thin film transistor Tr is disposed on the substrate 102. In FIG. 2, the thin film transistor Tr is disposed directly on the substrate 102. Alternatively, a buffer layer can be disposed on the substrate 102 and the thin film transistor Tr can be disposed on the buffer layer. For example, the buffer layer can comprise, but is not limited to, silicon oxide (SiOₓ) and/or silicon nitride (SiNₓ,) (wherein 0 < x ≤ 2).

The thin film transistor Tr can comprise a semiconductor layer 110, a gate electrode 114, a source electrode 130 and a drain electrode 132. The thin film transistor Tr can be the driving thin film transistor Td (FIG. 1).

The semiconductor layer 110 is disposed on the substrate 102. In one implementation, the semiconductor layer 110 can comprise an oxide semiconductor material. When the semiconductor layer 110 comprises the oxide semiconductor material, a light shielding pattern can be disposed under the semiconductor layer 110. The light shielding pattern can prevent the light from being incident to the semiconductor layer 110, and thereby the semiconductor layer 110 from being deteriorated by the light. In another implementation, the semiconductor layer 110 can comprise a polycrystalline semiconductor. In this case, impurity can be doped to both sides of the semiconductor layer 110.

A gate insulating layer 112 can be disposed on the semiconductor layer 110 with covering the entire substrate 102. For example, the gate insulating layer 112 can comprise, but is not limited to, an inorganic insulating material such as silicon oxide (SiOₓ) and/or silicon nitride (SiNₓ) (wherein 0 < x ≤ 2).

The gate electrode 114 including a conductive material such as metal is disposed on the gate insulating layer 112 corresponding to a center of the semiconductor layer 110. For example, the gate electrode 114 can comprise, but is not limited to, a metal component such as copper (Cu), molybdenum (Mo), titanium (Ti), aluminum (Al), gold (Au), and silver (Ag). The gate electrode 114 can have a mono-layer structure or a multi-layer structure. In FIG. 2, while the gate insulating layer 112 can be disposed on the entire substrate 102, but the gate insulating layer 112 can be patterned as the gate electrode 114.

An interlayer insulating layer 120 is disposed on the gate electrode 114 with covering the entire substrate 102. For example, the interlayer insulating layer 120 can comprise, but is not limited to, an inorganic insulating material such as silicon oxide (SiOₓ) and silicon nitride (SiNₓ) (wherein 0 < x ≤ 2) or an organic material such as benzocyclobutene and/or photo-acryl.

The interlayer insulating layer 120 has first and second semiconductor contact holes 122 and 124 that expose or do not cover the both sides of the semiconductor layer 110. The first and second semiconductor contact holes 122 and 124 are located spaced apart from the gate electrode 114 at both sides of the gate electrode 114. In FIG. 2, the first and second semiconductor contact holes 122 and 124 are disposed in the interlayer insulating layer 120 and the gate insulating layer 112. In another implementation, when the gate insulating layer 112 is patterned as the gate electrode 114, the first and second semiconductor contact holes 122 and 124 can be formed in only the interlayer insulating layer 120.

The source electrode 130 and the drain electrode 132 comprising a conductive material such as metal component are disposed on the interlayer insulating layer 120. The source electrode 130 and the drain electrode 132 are spaced apart from each other with centering the gate electrode 114, and contact to both sides of the semiconductor layer 110 through the first and second semiconductor contact holes 122 and 124.

For example, the source electrode 130 and the drain electrode 132 can comprise, but is not limited to, the metal component such as copper (Cu), molybdenum (Mo), titanium (Ti), aluminum (Al), gold (Au) and/or silver (Ag). The source electrode 130 and the drain electrode 132 can have a mono-layer structure or a multi-layer structure.

In FIG. 2, the thin film transistor Tr has a coplanar structure where the gate electrode 114, the source electrode 130 and the drain electrode 132 are disposed on the semiconductor layer 110. In another implementation, the thin film transistor can have an inverted staggered structure where the gate electrode is disposed under the semiconductor layer and the source electrode and the drain electrode are disposed on the semiconductor layer. In this case, the semiconductor layer can comprise amorphous silicon.

A planarization layer 134 is disposed on the source electrode 130 and the drain electrode 132 with covering the entire substrate 102. The planarization layer 134 can be disposed with covering the thin film transistor Tr.

The planarization layer 134 has a flat surface and has a drain contact hole that exposes or do not cover the drain electrode 132. For example, the planarization layer 134 can comprise, but is not limited to, an inorganic insulating material such as silicon oxide (SiOₓ) and silicon nitride (SiNₓ) (wherein 0 < x ≤ 2) or an organic material such as benzocyclobutene and/or photo-acryl.

The light emitting diode D is disposed on the planarization layer 134. The light emitting diode comprises a first electrode 140 disposed on the planarization layer 134 and connected to the drain electrode 132, and an emissive layer 142 and a second electrode 144 that are laminated sequentially on the first electrode 140. As an example, the light emitting diode D can be positioned in each of the red (R) sub-pixel, the green (G) sub-pixel and the blue (B) sub-pixel and can emit red light, green light and blue light, respectively.

The first electrode 140 can be disposed separately in each sub-pixel region SP. The first electrode 110 can be an anode and can comprise a conductive material with relatively high work function value, for example, a transparent conductive oxide (TCO). For example, the first electrode 142 can comprise, but is not limited to, indium-tin-oxide (ITO), indium-zinc-oxide (IZO), indium-tin-zinc-oxide (ITZO), tin oxide (SnO), zinc oxide (ZnO), indium-copper-oxide (ICO) and/or aluminum: zinc oxide (AZO).

In one implementation, the first electrode 142 can have a mono-layer structure of the transparent conductive oxide. In another implementation, the first electrode can have a bi-layer structure or a triple-layer structure with further comprising a reflective layer. In this case, the first electrode 140 can be a reflective electrode.

In one implementation, the reflective layer can comprise, but is not limited to, silver (Ag), an alloy including silver (Ag) and at least one of palladium (Pd), copper (Cu), indium (In) and neodymium (Nd), and/or an aluminum-palladium-copper (APC) alloy. For example, the first electrode 140 can have a bi-layer structure of Ag/ITO or APC/ITO or a triple-layer structure of ITO/APC/ITO.

The bank layer 146 is disposed on the planarization layer 134 with covering the periphery of the first electrode 140. The bank layer 146 exposes or do not cover the center of the first electrode 140 corresponding to the sub-pixel region SP. In addition, a spacer 148 may be disposed on the bank layer 140. The bank layer 146 and the spacer 148 can comprise the same material. For example, the bank layer 146 and the spacer 148 can comprise, but is not limited to, a black pigment and a photo-sensitive polymer.

The emissive layer 142 is disposed on the first electrode 140. As an example, the emissive layer 142 can have a mono-layer structure of an emitting material layer (EML).

The EML can comprise an organic luminescent material or an inorganic luminescent material. In other words, the light emitting display device 100 can be an organic light emitting display device or an inorganic light emitting display device.

In the organic light emitting display device, the EML can comprise a host and a dopant as an emitter. The EML can comprise a red host and a red dopant in the red sub-pixel. The EML can comprise a green host and a green dopant in the green sub-pixel. The EML can comprise a blue host and a blue dopant in the blue sub-pixel. In the inorganic light emitting display device, the EML can comprise quantum dots as the inorganic luminescent material.

In another implementation, the emissive layer 142 can have a multi-layer structure. As an example, the emissive layer 142 can further comprise at least one of a hole injection layer (HIL), a hole transport layer (HTL), an electron blocking layer (EBL), a hole blocking layer (HBL), an electron transport layer (ETL) and an electron injection layer (EIL) in addition to the EML.

In one implementation, the light emitting diode D can emit white light in each of the red sub-pixel, the green sub-pixel and the blue sub-pixel. For example, the emissive layer 142 of the light emitting diode D can have a stack structure including multiple emitting parts and at least one charge generation layer (CGL) disposed between the multiple emitting parts.

The second electrode 144 is disposed on the substrate 102 on which the emissive layer 142 is disposed. The second electrode 144 can be disposed on the entire display area and can comprise a conductive material with relatively low work function value to act as a cathode. For example, the second electrode 144 can comprise, but is not limited to, aluminum (Al), magnesium (Mg), calcium (Ca), silver (Ag), and alloys thereof such as magnesium silver alloy. The second electrode 144 can have a thin thickness to have a light-transmissive (semi-transmissive) property.

An encapsulation layer (encapsulation film) 150 is disposed on the second electrode 144 in order to prevent external oxygen from infiltrated to the light emitting diode D. In one implementation, the encapsulation layer 150 can have, but is not limited to, a lamination structure of a first inorganic insulating layer 152, an organic insulating layer 154 and a second inorganic insulating layer 156.

Each of the first inorganic insulating layer 152 and the second inorganic insulating layer 156 can comprise, but is not limited to, an inorganic insulating material such as silicon oxide (SiOₓ) and silicon nitride (SiNₓ) (wherein 0 < x ≤ 2). The organic insulating layer 154 can comprise, but is not limited to, an organic insulating material such as an epoxy resin, photo-acryl (or photosensitive acrylic polymer). The organic insulating layer 154 is disposed between the first inorganic insulating layer 152 and the second inorganic insulating layer 156. The organic insulating layer 154 makes the lower step to flatten and provides a flat surface.

A touch sensor 160 can be disposed on the encapsulation layer 150 to provide a sensing function. As an example, the touch sensor 160 can comprise a first buffer layer 162, a first touch insulating layer 164, a second touch insulating layer 166, a bridge electrode BRG and a plurality of touch electrode 168. Alternatively, the touch sensor 160 can further comprise a second buffer layer 169 covering the touch electrode 168 and the second touch insulating layer 166.

The first buffer layer 162 is disposed on the second inorganic insulating layer 156 constituting the encapsulation layer 150. The first buffer layer 162 can be disposed directly on the second inorganic insulating layer 156 to improve adhesive force between the touch sensor 160 and the second inorganic insulating layer 156. Particularly, the first buffer layer 162 can improve the adhesive force between the metal layer such as the bridge electrode BRG and the second inorganic insulating layer 156. The first buffer layer 162 can comprise an inorganic insulating layer. For example, the first buffer layer 162 can comprise, but is not limited to, an inorganic material such as silicon oxide (SiOₓ), silicon nitride (SiNₓ) and aluminum oxide (AlOₓ) (wherein 0 < x ≤ 2).

The bridge electrode BRG is disposed on the first buffer layer 162, the first touch insulating layer 164 and the second touch insulating layer 166 are disposed with covering the bridge electrode BRG, and the plurality of touch electrodes 168 can be disposed on the first and second touch insulating layers 164 and 166. The bridge electrode BRG can be configured to electrically connect to at least a portion of the plurality of touch electrodes 168. For example, a contact hole can be formed in the first touch insulating layer 164 and the second touch insulating layer 166, but is not limited thereto.

In one implementation, the first touch insulating layer 164 and the second touch insulating layer 166 can comprise an inorganic insulating material and/or an organic insulating material. In another implementation, the first touch insulating layer 164 and the second touch insulating layer 166 can have a multi-layer structure where an inorganic insulating material layer and an organic insulating material layer are disposed alternately. For example, the touch insulating layer can comprise the first touch insulting layer 164 having an inorganic material layer and covering the bridge electrode BRG and the second touch insulating layer 166 having an organic material layer and disposed on the first touch insulating layer 164.

For example, the first touch insulating layer 164 can comprise, but is not limited to, an inorganic insulating material selected from silicon oxide (SiOₓ), silicon nitride (SiNₓ) (wherein 0 < x ≤ 2) and a combination thereof. As an example, the second touch insulating layer 166 can comprise, but is not limited to, an organic insulating material selected from an acryl-containing resin, a polyester-containing resin, an epoxy-containing resin, a silicone-containing resins and combinations thereof.

Each of the plurality of touch electrodes 168 can be disposed correspondingly to the boundary of sub-pixel region SP. As an example, each of the plurality of touch electrodes 168 can be disposed on the touch insulating layers 164 and 166 correspondingly to the bank layer 146 and/or a black matrix 180, but the alignment structure of the touch electrode 168 is not limited thereto. For example, the touch electrode 168 can comprise, but is not limited to, a transparent metal oxide such as ITO, IZO, ITZO, SnO, ZnO, ICO and/or AZO.

The second buffer layer 169 can be disposed with covering the plurality of touch electrodes 168. As an example, the second buffer layer 169 can comprise, but is not limited to, the inorganic insulating material as the first buffer layer 162. In some implementation, the touch sensor 160 can be omitted.

An insulating layer 170 can be disposed on the encapsulation layer 150 and/or the touch sensor 160 with covering the entire substrate 102. The black matrix 180 and a color control pattern 190 are disposed on the insulating layer 170. The black matrix 180 and the color control pattern 190 can reduce the decrease in visibility and contrast ratio of the light emitting display device 100 due to external light while maintaining high luminance of light emitted from the light emitting diode D.

The black matrix 180 can be disposed correspondingly to the non-emission area NEA on the insulating layer 170. The black matrix 180 has an opening corresponding to the light emitting diode D. For example, the black matrix 180 can comprise a light-shielding material and/or a light-absorbing material such as a black resin and/or carbon black.

In an exemplary implementation, the bank layer 146 disposed correspondingly to the non-emission area NEA can be further extended toward the emission area EA compared to the black matrix 180. A side 147 of the bank layer 146 on the side of the emission area EA covering the first electrode 140, *i.e.,* the side 147 of the bank layer 146 in contact with the light emitting diode D, can be disposed toward the emission area EA rather than a side 181 of the black matrix 180 in the emission area EA in which the color control pattern 190 is disposed, *i.e.,* the side 181 of the black matrix in contact with the color control pattern 190, and can have a pull-back structure. In other words, compared to the side 181 of the emission area EA of the black matrix 180, the side 147 of the emission area EA of the bank layer 146 can extend further toward the emission area EA by a protruding length L.

The color filter pattern 190 also called color control pattern can be a color filter pattern and/or a color conversion pattern, and can be disposed corresponding to the opening of the black matrix 180. So, the color filter pattern 190 overlaps the light emitting diode in the emission area EA. As an example, when the sub-pixel region SP includes the red sub-pixel, the green sub-pixel and the blue sub-pixel, the color control pattern 190 can comprise a red color filter pattern corresponding to the red sub-pixel, a green color filter pattern corresponding to the green sub-pixel and a blue color filter pattern corresponding to the blue sub-pixel.

The red color filter pattern can comprise at least one of a red dye and a red pigment.

The green color filter pattern can comprise at least one of a green dye and a green pigment.

The blue color filter pattern can comprise at least one of a blue dye and a blue pigment.

In another implementation, when the color control pattern 190 is the color conversion pattern, the color control pattern 190 can comprise quantum dots. As an example, when the sub-pixel region SP includes the red sub-pixel, the green sub-pixel and the blue sub-pixel, the color conversion pattern can comprise a red color conversion pattern which corresponds to the red sub-pixel and comprises red quantum dots, a green color conversion pattern which corresponds to the green sub-pixel and comprises green quantum dots, and a blue color conversion pattern which corresponds to the blue sub-pixel and comprises blue quantum dots. In some implementations, the blue color conversion pattern can be omitted.

A passivation layer 196 can be disposed on the black matrix 180 and the color control pattern 190. For example, the passivation layer 196 can comprise, but is not limited to, an inorganic insulating material selected from silicon oxide (SiOₓ), silicon nitride (SiNₓ) (wherein 0 < x ≤ 2) and a combination thereof.

As described above, the insulating layer 170 is disposed on the encapsulation layer 150 or the touch sensor 160. A plurality of lower uneven patterns 172 is positioned on a surface of the insulating layer 170 corresponding to the non-emission area NEA. The black matrix layer 180 extends into the valleys 174b of the plurality of lower uneven patterns 172. A plurality of upper uneven patterns 182 is positioned on a surface of the black matrix 180 disposed correspondingly to the non-emission area NEA, for example, the surface of the black matrix 180 corresponding to the plurality of lower uneven patterns 172. E.g. the lower and upper uneven patterns 172 and 182 overlapp each other in the non emission area NEA.

The light-absorbing surface area in the black matrix 180 can be increased by introducing the plurality of lower uneven patterns 172 and the plurality of upper uneven patterns 182 each of which can have a corrugated or irregular shape. In addition, by arranging the plurality of lower uneven patterns 172 and the plurality of upper uneven patterns 182, reflection of external light incident on the light emitting diode D can be reduced and re-absorption of the external light can be increased, thereby preventing rainbow mura caused by external light.

In an exemplary implementation, at least one of the plurality of lower uneven patterns 172 and the plurality of upper uneven patterns 182 can extend to a peripheral area of the color control pattern 190. When the plurality of lower uneven patterns 172 and/or the plurality of upper uneven patterns 182 extend to the peripheral area of the color control pattern 190, it is possible to reduce stains caused by external light by re-absorbing the external light incident on the peripheral area of the color control pattern 190. So, at least at one side of the color control pattern 190 the lower and/or upper uneven pattern is in contact by the material of color control pattern 190.

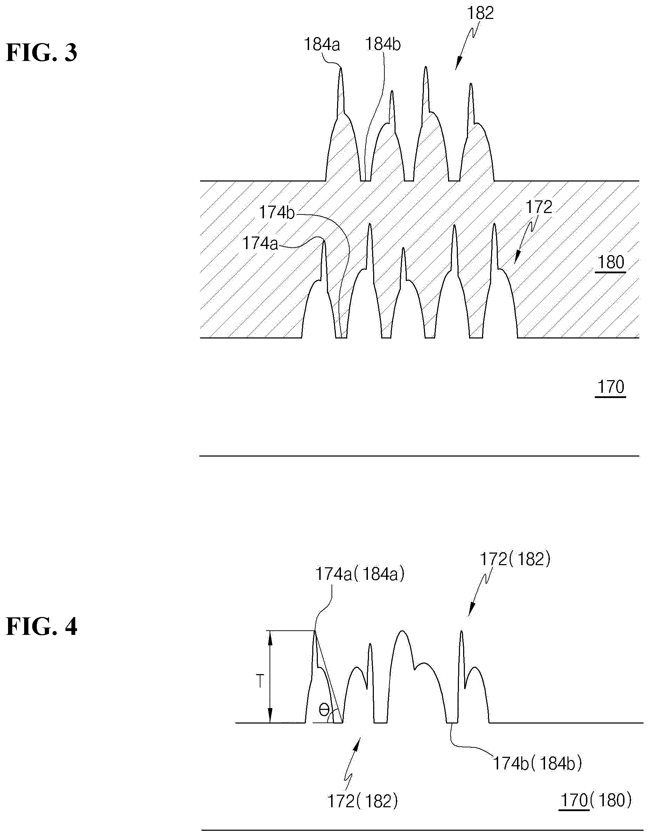

The shapes of the uneven patterns positioned in the non-emission area NEA will be described in more detail. FIG. 3 illustrates a schematic cross-sectional view of an uneven patterns structure in accordance with the first implementation of the disclosure. FIG. 4 illustrates a schematic cross-sectional view of the peaks and valleys in the uneven patterns in accordance with the first implementation of the disclosure.

Referring to FIG. 3, the plurality of lower uneven patterns 172 positioned on the surface of the insulating layer 170 can have a shape in which peaks (convex portions) 174a and valleys (concave portions) 174b are alternately formed. In addition, the plurality of upper uneven patterns 182 positioned on the surface of the black matrix 180 can also have a shape in which peaks 184a and valleys 184b are alternately formed. A ground area of a peak pattern is larger than a ground area of a valley.

In an exemplary implementation, each of the plurality of lower uneven patterns 172 and/or the plurality of upper uneven patterns 182 can have a corrugated pattern shape. In other words, the length and width of each of the peaks 174a and 184a and the length and width of each of the valleys 174b and 184b in the plurality of lower uneven patterns 172 and the plurality of upper uneven patterns 182, respectively, can be different. As the plurality of lower uneven patterns 172 and the plurality of upper uneven patterns 182 have the corrugated pattern shape, it is possible to reduce the reflection of external light caused by irregular reflection and to maximize the re-absorption of external light.

In another exemplary implementation, the plurality of lower uneven patterns 172 and the plurality of upper uneven patterns 182 can be disposed to be misaligned with each other. That is, the peaks 174a of the plurality of lower uneven patterns 172 can be disposed at positions that do not correspond to the peaks 184a of the plurality of upper uneven patterns 182. In addition, the valleys 174b of the plurality of lower uneven patterns 172 can be disposed at positions that do not correspond to the valleys 184b of the plurality of upper uneven patterns 182.

For example, the peaks 174a of the plurality of lower can be disposed at positions corresponding to the valleys 184b of the plurality of upper uneven patterns 182. In addition, the valleys 174b of the plurality of lower uneven patterns 172 can be disposed at positions corresponding to the peaks 184a of the plurality of upper uneven patterns 182. Accordingly, it is possible to reduce the reflection of external light caused by irregular reflection and to maximize re-absorption of external light.

Referring to FIG. 4, the angle θ between the peaks 174a and 184a and the valleys 174b and 184b in the plurality of lower uneven patterns 172 and the plurality of upper uneven patterns 182 that are disposed on the surfaces of the insulating layer 170 and the black matrix 180, respectively, can be 15° or more, for example, 15° or more and 60° or less, or 15° or more and 45° or less, but is not limited thereto. The reflection of external light can be reduced by controlling the angle θ between the peaks 174a and 184a and the valleys 174b and 184b. For example, the height of the peaks 174a and 184a based on the valleys 174b and 184b can be 0.5 µm to 10 µm, for example, 1 µm to 5 µm, but is not limited thereto.

The light emitting display device 100 in accordance with the first implementation includes the black matrix 180 and the color control pattern 190 disposed on the encapsulation layer 150 in place of a polarizer. The black matrix 180 and the color control pattern 190 can act as reflective layers, thereby reducing reflection of external light. Accordingly, a decrease in light emission luminance due to the polarizer can be reduced, and a decrease in display quality due to reflection of external light can be prevented.

Also, an ambient light diffraction mural can occur due the step difference caused by the thin film transistor Tr. In addition, as the diffraction of the reflected external light is further strengthened by the color control pattern 190, a rainbow mura can occur due to interference between adjacent sub-pixel regions SPs. However, when the plurality of lower uneven patterns 172 are positioned on the surface of the insulating layer 170 and the plurality of upper uneven patterns 182 are positioned on the surface of the black matrix 180 in accordance with the first implementation of the disclosure, the black matrix 180 can re-absorb the reflected light generated by reflecting the incident external light. Accordingly, it is possible to reduce or prevent external light reflection diffraction stains and/or rainbow mura.

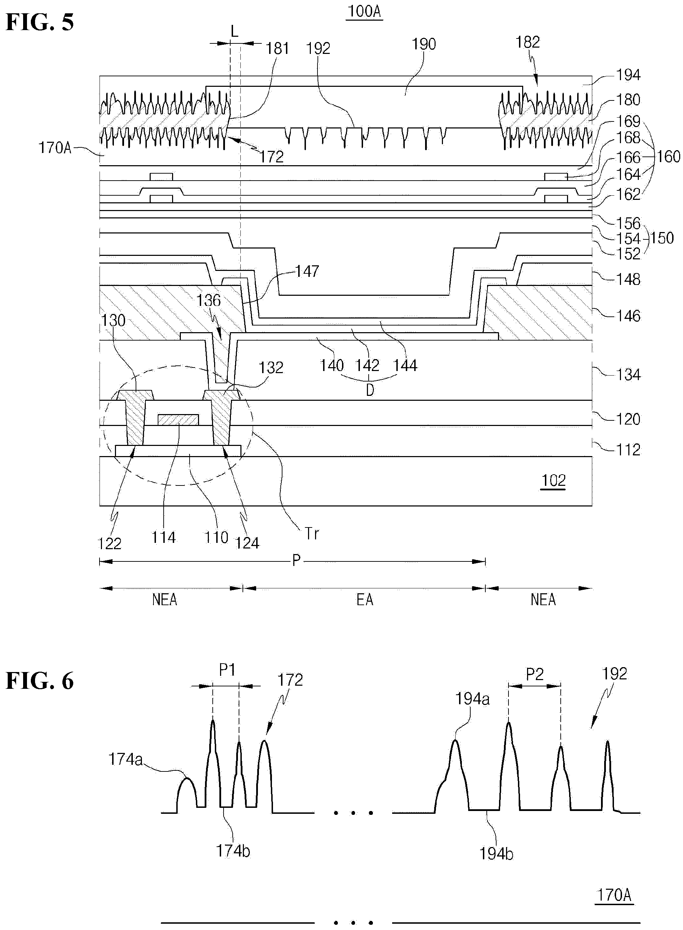

In another implementation, a plurality of uneven patterns can be positioned on the color control pattern 190. FIG. 5 illustrates a schematic cross-sectional view of a light emitting display device in accordance with a second implementation of the disclosure.

Referring to FIG. 5, a light emitting display device 100A in accordance with the second implementation comprises a substrate 102 having an emission area EA and a non-emission area NEA, a thin film transistor Tr disposed on the substrate 102, a light emitting diode D disposed correspondingly to the emission area EA on the substrate 102 and connected to the thin film transistor Tr, and a bank layer 146 corresponding to the non-emission area NEA on the substrate 102 and disposed adjacently to the light emitting diode D.

An encapsulation layer 150 is disposed on the light emitting diode D and the bank layer 146. Optionally, a touch sensor 160 can be disposed on the encapsulation layer 150. An insulating layer 170A of an organic material is disposed on the encapsulation layer 150. A black matrix 180 is disposed on the insulating layer 170A corresponding to the non-emission area NEA and a color control pattern 190 is disposed on the insulating layer 170A corresponding to the emission area EA.

Similar to the first implementation, a plurality of lower uneven patterns 172 are positioned on the surface of the insulating layer 170A corresponding to the non-emission area NEA and a plurality of upper uneven patterns 182 are positioned on the surface of the black matrix 180. As an example, at least one of the plurality of lower uneven patterns 172 and the plurality of upper uneven patterns 182 can extend to the peripheral area of the color control pattern 190.

In the second implementation, a plurality of light control uneven patterns 192 are further positioned on the surface of the insulating layer 170A corresponding to the emission area EA. As an example, the plurality of light control uneven patterns 192 can be positioned only on the surface of the insulating layer 170A corresponding to the central area of the color control pattern 190 in which the plurality of lower uneven patterns 172 and the plurality of upper uneven patterns 182 are not positioned.

FIG. 6 illustrates a schematic cross-sectional view of an uneven patterns structure in accordance with the second implementation of the disclosure.

Referring to FIG. 6, the plurality of light control uneven patterns 192 can have a shape in which peaks 194a and valleys 194b are alternately formed. In an exemplary implementation, the plurality of lower uneven patterns 172 positioned on the surface of the insulating layer 170A corresponding to the non-emission area NEA (FIG. 5) can have a different shape from the plurality of light control uneven patterns 192 positioned on the surface of the insulating layer 170A corresponding to the emission area EA (FIG. 5). For example, an average pitch P1, which is a distance between the peak 174a and the adjacent peak 174a or a distance between the valley 174b and the adjacent valley 174b, in the plurality of lower uneven patterns 172 can be smaller than an average pitch P2, which is a distance between the peak 194a and the adjacent peak 194a or a distance between the valley 194b and the adjacent valley 194b, in the plurality of light control uneven patterns 192.

In one implementation, the average pitch P1 in the plurality of lower uneven patterns 172 can be, but is not limited to, 0.5 µm to 10 µm, for example, 1 µm to 10 µm. The average pitch P2 in the plurality of light control uneven patterns 192 can be, but is not limited to, 3 µm to 20 µm, for example, 5 µm to 20 µm.

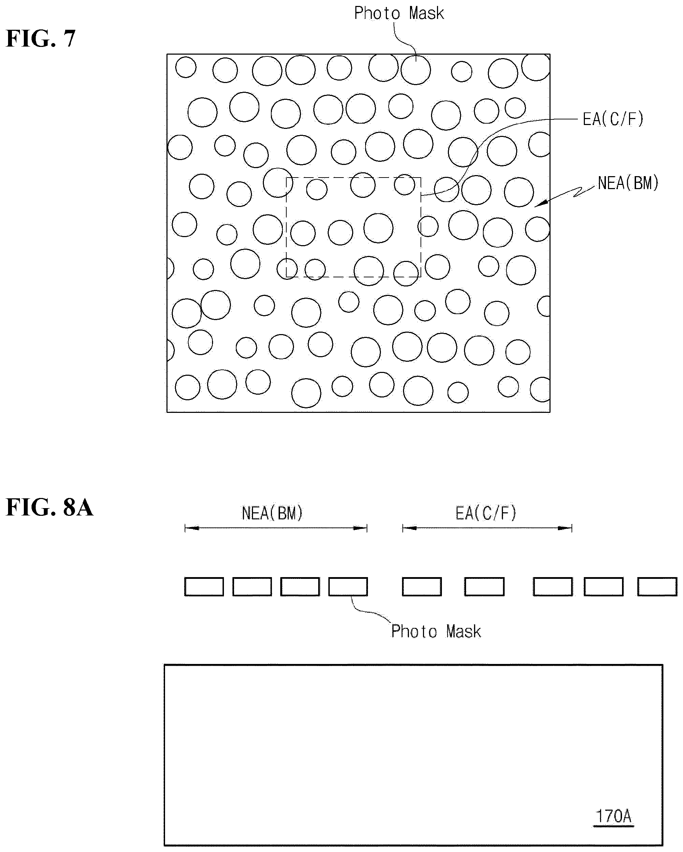

A process of positioning or forming the plurality of lower uneven patterns 172, the plurality of upper uneven patterns 182 and the plurality of light control uneven patterns 192 shown in FIGS. 5 and 6 will be described. FIG. 7 illustrates a schematic plane view of a photomask arrangement located in an emission area and a non-emission area for forming uneven patterns in accordance with an exemplary implementation of the disclosure. FIGS. 8A to 8E illustrates a schematic cross-sectional view of a process of forming the plurality of uneven patterns on the insulating layer and the black matrix in accordance with the second implementation of the disclosure.

Referring to FIG. 7, photomasks are relatively densely arranged in the non-emission area NEA of the black matrix area BM. On the other hand, photomasks are relatively less densely arranged in the emission area EA or the color filter area C/F. Through those photomask arrangements, the plurality uneven patterns having different average pitches P1 and P2, as illustrated in FIG. 6, can be disposed on the insulating layer 170A.

Referring to FIG. 8A, a first or primary photolithography process is performed by arranging the photomasks on the laminated insulating layer 170A to form the plurality of uneven patterns on the surface of the insulating layer 170A. In this case, the photomasks are relatively densely arranged in the area corresponding to the non-emission area NEA, and the photomasks are relatively less densely arranged in the area corresponding to the emission area EA. For example, the photomask can be a negative type.

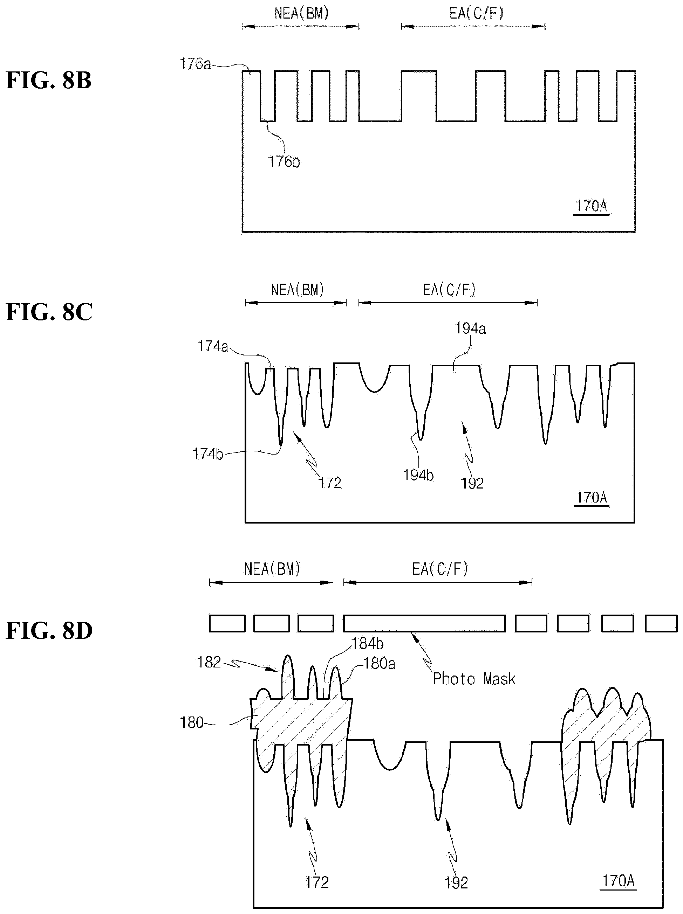

Referring to FIG. 8B, when the exposure process is performed, a plurality of grooves (etched portions, etched patterns) 176b having a vertical cross-sectional shape are formed on the surface of the insulating layer 170A corresponding to the area exposed to light. On the other hand, the surface of the insulating layer 170A corresponding to the area covered by the photomask and not exposed to light maintains its original shape and has a plurality of flat portions (non-etched portions) 176a that protrude relatively compared to the plurality of grooves 176b.

Subsequently, referring to FIG. 8C, when the development process and the low-temperature curing process are performed, peaks 174a and valleys 174b are densely formed on the surface of the insulating layer 170A corresponding to the non-emission area NEA, and the plurality of lower uneven patterns 172 having the relatively small average pitch P1 are positioned. Furthermore, since the peaks 194a and the valleys 194b are not densely formed on the surface of the insulating layer 170A corresponding to the emission area EA, the plurality of light control uneven patterns 192 with the relatively large pitch P2 are positioned. For example, the development process can be performed for 10 seconds to 60 seconds, and the low-temperature curing process can be performed at a temperature of 80°C to 120°C, but is not limited thereto.

Subsequently, referring to FIG. 8D, a plurality of photomasks having a relatively high density are disposed in the non-emission area NEA and a photomask is disposed in the entire emission area EA to perform a secondary photolithography process, exposure, development and low-temperature curing process. The secondary photolithography process can be performed under the same conditions as the primary photolithography process. Therefore, the peaks 184a and the valleys 184b are densely formed on the surface of the black matrix 180 corresponding to the non-emission area NEA, and the plurality of upper uneven patterns 182 with a relatively small average pitch are positioned on the surface of the black matrix 180.

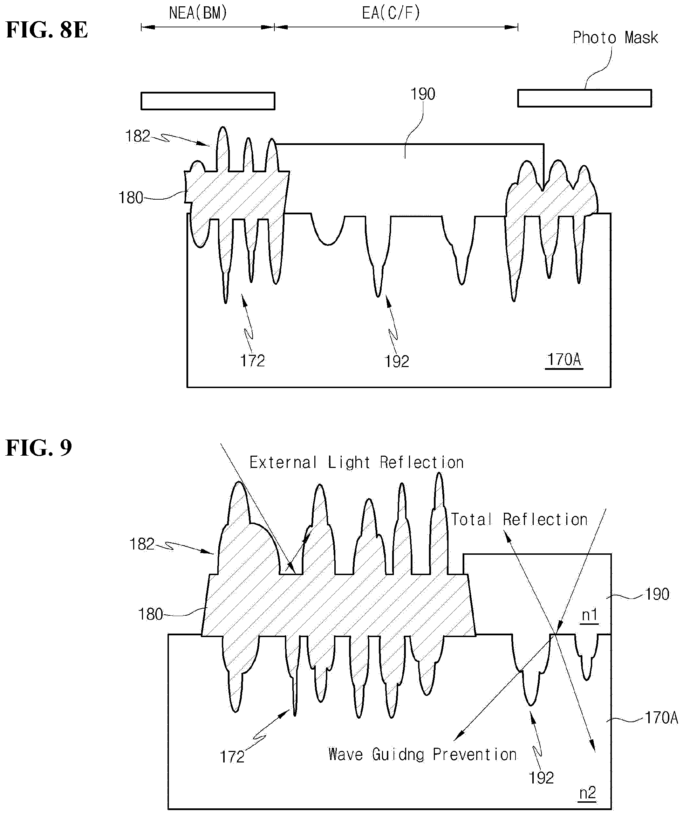

Subsequently, referring to FIG. 8E, a photosensitive composition including a color material capable of transmitting only a part of light emitted from the light emitting diode is coated on an area corresponding to the emission area EA, and a third photolithography process is performed in a state in which a photomask is disposed in the non-emission area NEA. Accordingly, the color control pattern 190 such as the color filter pattern can be disposed on the insulating layer 170A on which the plurality of light control uneven patterns 192 are positioned.

FIG. 9 illustrates a schematic cross-sectional view of which external light reflection is controlled by the plurality of uneven patterns in accordance with the second implementation of the disclosure.

Referring to FIG. 9, as the surface area of the black matrix increases due to the plurality of lower uneven patterns 172 and the plurality of upper uneven patterns 182, the surface area capable of absorbing external light in the black matrix 180 can absolutely increases. In addition, as least a portion of the external light incident on the black matrix 180 is reflected from the plurality of upper uneven patterns 182 positioned on the surface of the black matrix 180 and is reflected into the black matrix 180.

In addition, the external light incident on the color control pattern 190 is dispersed and progressed to the inside of the light emitting display device 100A by the color control pattern 190 having the plurality of light control uneven patterns 192. Thus, while preventing wave guiding, re-absorption of the external light can be increased. In an implementation, a refractive index n1 of the color control pattern 190 can be greater than a refractive index n2 of the insulating layer 170A. Accordingly, a portion of the external light incident on the color control pattern 190 can be prevented from proceeding to the insulating layer 170A and the light emitting diode D (FIG. 5) disposed under the insulating layer 170A, and be reflected to the outside by total reflection.

In one implementation, the refractive index n1 of the color control pattern 190 can be greater than the refractive index n2 of the insulating layer 170A by 0.07 or more, for example, 0.07 to 0.2. For example, the refractive index n1 of the color control pattern 190 can be 1.60 to 1.80, for example, 1.60 to 1.70, and the refractive index n2 of the insulating layer 170 can be 1.4 to 1.55, for example, 1.4 to 1.5, but is not limited thereto.

The amount of external light incident on the light emitting diode D and the thin film transistor Tr (FIG. 5) can be greatly decreased by applying the plurality uneven patterns 172, 182 and 192. Accordingly, the reflection diffraction stains or spots and/or rainbow stains caused by the external light can be greatly reduced.

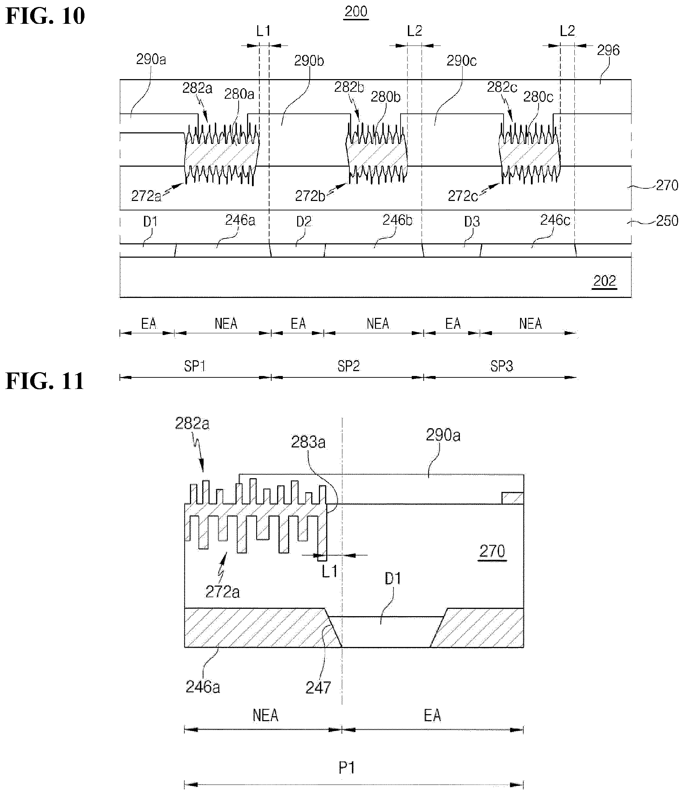

FIG. 10 illustrates a schematic cross-sectional view of a light emitting display device in accordance with a third implementation of the disclosure.

Referring to FIG. 10, a light emitting display device 200 includes a substrate 202 which includes a first sub-pixel region SP1, a second sub-pixel region SP2 and a third sub-pixel region SP3. Each of the first sub-pixel region SP1, the second sub-pixel region SP2 and the third sub-pixel region SP3 can comprise the emission area EA and the non-emission area NEA.

For example, the first sub-pixel region SP1 can comprise a green sub-pixel, one of the second sub-pixel region SP2 and the third sub-pixel region SP3 can comprise a red sub-pixel, and the other of the second sub-pixel region SP2 and the third sub-pixel region SP3 can comprise a blue sub-pixel. In one implementation, the second sub-pixel region SP2 can comprise a red sub-pixel and the third sub-pixel region SP3 can comprise blue sub-pixel. Alternatively or additionally, the substrate 200 can further comprise a fourth sub-pixel region that can comprise a white sub-pixel.

A first light emitting diode D1 is disposed correspondingly to the emission area EA on the substrate 202 and a first bank layer 246a is disposed correspondingly to the non-emission area NEA adjacent to the first light emitting diode D1 in the first sub-pixel region SP1. A second light emitting diode D2 is disposed correspondingly to the emission area EA on the substrate 202 and a second bank layer 246b is disposed correspondingly to the non-emission area NEA adjacent to the second light emitting diode D2 in the second sub-pixel region SP1. A third light emitting diode D3 is disposed correspondingly to the emission area EA on the substrate 202 and a third bank layer 246c is disposed correspondingly to the non-emission area NEA adjacent to the third light emitting diode D3 in the third sub-pixel region SP3. Each of the first light emitting diode D1, the second light emitting diode D2 and the third light emitting diode D3 can emit white light.

An encapsulation layer 250 is disposed on the light emitting diodes D1, D2 and D3 and the bank layers 246a, 246b and 246c, and an insulating layer 270 is disposed on the encapsulation layer 250.

For the convenience of explanation, the components under the light emitting diodes D1, D2 and D3 and the bank layers 246a, 246b and 246c are omitted in FIG. 10. As an example, a thin film transistor Tr (FIGS. 2 and 5) connected to each of the first light emitting diode D1, the second light emitting diode D2 and the third light emitting diode D3 can be disposed on the substrate 202 in each of the first sub-pixel region SP1, the second sub-pixel region SP2 and the third sub-pixel region SP3, respectively. In addition, a touch sensor 160 (FIGS. 2 and 5) can be further disposed between the encapsulation layer 260 and the insulating layer 270.

A first black matrix 280a and a first color control pattern 290a are disposed on the insulating layer 270 in the first sub-pixel region SP1. A second black matrix 280b and a second color control pattern 290b are disposed on the insulating layer 270 in the second sub-pixel region SP2. A third black matrix 280c and a third color control pattern 290c are disposed on the insulating layer 270 in the third sub-pixel region SP3.

The first black matrix 280a, the second black matrix 280b and the third black matrix 280c can be disposed at a position corresponding to the non-emission area NEA in the first sub-pixel region SP1, the second sub-pixel region SP2 and the third sub-pixel region SP3, respectively. The first color control pattern 290a, the second color control pattern 290b and the third color control pattern 290c can be disposed at a position corresponding to the emission area EA in the first sub-pixel region SP1, the second sub-pixel region SP2 and the third sub-pixel region SP3, respectively.

For example, the first black matrix 280a, the second black matrix 280b, and the third black matrix 280c surround the first sub-pixel region SP1, the second sub-pixel region SP2, and the third sub-pixel region SP3, respectively, and can have openings corresponding to the emission area EA of the first sub-pixel region SP1, the second sub-pixel region SP2, and the third sub-pixel region SP3, respectively.

In one implementation, the first color control pattern 290a can be a green color filter pattern and/or a green color conversion pattern, the second color control pattern 290b can be a red color filter pattern and/or a red color conversion pattern, and the third color control pattern 290c can be a blue color filter pattern and/or a blue color conversion pattern.

A passivation layer 296 can be disposed on the first to third black matrices 280a, 280b and 280c and the first to third color control patterns 290a, 290b and 290c.

A plurality of first lower uneven patterns 272a can be positioned on a surface of the insulating layer 270 corresponding to the non-emission area NEA in the first sub-pixel region SP1, a plurality of second lower uneven patterns 272b can be positioned on a surface of the insulating layer 270 corresponding to the non-emission area NEA in the second sub-pixel region SP2, and a plurality of third lower uneven patterns 272c can be positioned on a surface of the insulating layer 270 corresponding to the non-emission area NEA in the third sub-pixel region SP3. Each of the plurality of first lower uneven patterns 272a, the plurality of second lower uneven patterns 272b, and the plurality of third lower uneven patterns 272c can have a shape same as the shape of the plurality of lower uneven patterns 272 illustrated in FIGS. 2 and 5, but is not limited thereto.

A plurality of first upper uneven patterns 282a can be positioned on a surface of the first black matrix 280a in the first sub-pixel region SP1, a plurality of second upper uneven patterns 282b can be positioned on a surface of the second black matrix 280b in the second sub-pixel region SP2, and a plurality of third upper uneven patterns 282c can be positioned on a surface of the third black matrix 280c in the third sub-pixel region SP3. Each of the plurality of first upper uneven patterns 282a, the plurality of second upper uneven patterns 282b, and the plurality of third upper uneven patterns 282c can have a shape same as the shape of the plurality of upper uneven patterns 282 illustrated in FIGS. 2 and 5, but is not limited thereto.

In an exemplary implementation, the structure of at least one of the plurality of first lower uneven patterns 272a and the plurality of first upper uneven patterns 282a positioned correspondingly to the non-emission area NEA in the first sub-pixel region SP1 can differ from the structure of at least one of the plurality of second lower uneven patterns 272b and the plurality of second upper uneven patterns 282b positioned correspondingly to the non-emission area NEA in the second sub-pixel region SP2 and/or the plurality of third lower uneven patterns 272c and the plurality of third upper uneven patterns 282c positioned correspondingly to the non-emission area NEA in the third sub-pixel region SP3.

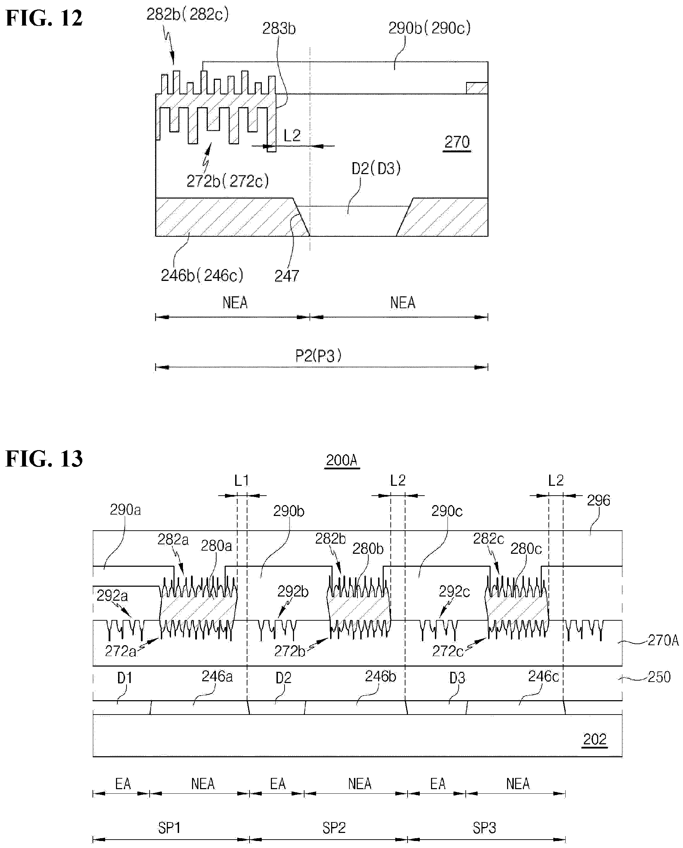

FIG. 11 illustrates a schematic cross-sectional view of an extension structure of the uneven patterns in a first sub-pixel region in accordance with the third implementation of the disclosure. FIG. 12 illustrates a schematic cross-sectional view of an extension structure of the uneven patterns in a second sub-pixel region and/or a third sub-pixel region in accordance with the third implementation of the disclosure.

Referring to FIG. 11, the plurality of first lower uneven patterns 272a and the plurality of first upper uneven patterns 282a positioned correspondingly to the non-emission area NEA in the first sub-pixel region SP1 can extend to a peripheral area of the first color control pattern 290a disposed correspondingly to the emission area EA in the first sub-pixel region SP1, respectively. Referring to FIG. 12, the plurality of second lower uneven patterns 272b, the plurality of second upper uneven patterns 282b, the plurality of third lower uneven patterns 272c, and the plurality of third upper uneven patterns 282c positioned correspondingly to the non-emission area NEA in the second sub-pixel region SP2 and the third sub-pixel region SP3 can extend to a peripheral area of the second color control pattern 290b and the third color control pattern 290c disposed correspondingly to the emission area EA in the second sub-pixel region SP2 and the third sub-pixel region SP3, respectively.

However, compared to the extension lengths of the second and third lower uneven patterns 272b and 272c and the second and third upper uneven patterns 282b and 282c each of which is positioned in the second and third sub-pixel regions SP2 and SP3, respectively, to the peripheral areas of the second and third color control patterns 290b and 290c, the plurality of first lower uneven patterns 272a and the plurality of first upper uneven patterns 282a positioned in the first sub-pixel region SP1 can have a larger extension length to a peripheral area of the first color control pattern 290a.

In other words, compared to the plurality of second and third lower uneven patterns 272b and 272c and the plurality of second and third upper uneven patterns 282b and 282c, the plurality of first lower uneven patterns 272a and the plurality of first upper uneven patterns 282b can have a shape further extending toward the emission area EA. Accordingly, the side 247 of the first bank layer 246a adjacent to the first light emitting diode D1 can be positioned toward the emission area EA by a relatively narrow Pull-Back length L1 compared to the inner side 283a of the first black matrix 280a having the plurality of first lower uneven patterns 272a and the plurality of first upper uneven patterns 282a. On the other hand, the side 247 of the second and third bank layers 246b and 246c adjacent to the second and third light emitting diodes D2 and D3, respectively, can be positioned toward the emission area EA by a relatively wide Pull-Back length L2 compared to the inner side 283b of the second and third black matrices 280b and 280c having the plurality of second and third lower uneven patterns 272b and 272c, and the plurality of second and third upper uneven patterns 282b and 282c.

In one implementation, the first sub-pixel region SP1 can comprise a green sub-pixel, one of the second sub-pixel region SP2 and the third sub-pixel region SP3 can comprise a red sub-pixel, and the other of the second sub-pixel region SP2 and the third sub-pixel region SP3 can comprise a blue sub-pixel.

For example, the lifespan of the green light emitted through the first color control pattern 290a in the first sub-pixel region SP1 is longer than the lifespan of the red light and the blue light emitted through the second and third color control patterns 290b and 290c in the second and third sub-pixel regions SP2 and SP3, respectively. Even if the side 283a of the first black matrix 280a extends slightly toward the emission area EA compared to the side 283b of the second and third black matrices 280b and 280c, increasing the voltage applied to the first sub-pixel region SP1 can induce light of uniform intensity to be emitted from the first to third sub-pixel regions SP1, SP2 and SP3.

For example, the Pull-Back length L1 in the first sub-pixel region SP1 can be 1 µm to 3 µm, and the Pull-Back length L2 in the second and third sub-pixel regions SP2 and SP3 can be 3.5 µm to 10 µm, for example, 4 µm to 7 µm, but is not limited thereto. In another implementation, the side 283a of the first black matrix 280a can be disposed at substantially the same position as the side 247 of the first bank layer 246. In other words, in some implementations, the first sub-pixel region SP1 can have no Pull-Back length L1.

In accordance with the third implementation, the plurality of lower uneven patterns 272a, 272b and 272c are positioned on the surface of the insulating layer 270 corresponding to the non-emission area NEA, and the plurality of upper uneven patterns 282a, 282b and 282c are positioned on the surface of the first to third black matrices 280a, 280b and 280c, respectively. Accordingly, the amount of external light absorbed by the first to third black matrices 280a, 280b and 280c can be increased, reflection of external light caused by irregular reflections can be minimized, and re-absorption of external light can be increased. Thus, it is possible to minimize stains such as rainbow mura.

FIG. 13 illustrates a schematic cross-sectional view of a light emitting display device in accordance with a fourth implementation of the disclosure.

Compared to the light emitting display device 200 illustrated in FIG. 10, a light emitting display device 200A in FIG. 13 can further comprise a plurality of light control uneven patterns 292a, 292b and 292c each of which is positioned on the surface of the insulating layer 270A corresponding to the emission area EA in each of the first to third sub-pixel regions SP1, SP2 and SP3.

Referring to FIG. 13, a plurality of first light control uneven patterns 292a are further positioned on a surface of the insulating layer 270A corresponding to the emission area EA in the first sub-pixel region SP1. A plurality of second light control uneven patterns 292b are further positioned on a surface of the insulating layer 270A corresponding to the emission area EA in the second sub-pixel region SP2. A plurality of third light control uneven patterns 292c are further positioned on a surface of the insulating layer 270A corresponding to the emission area EA in the third sub-pixel region SP3.

For example, each of the plurality of first light control uneven patterns 292a, the plurality of second light control uneven patterns 292b, and the plurality of third light control uneven patterns 292c can be positioned correspondingly to the central area of the first color control pattern 290a, the second color control pattern 290b and the third color control pattern 290c, respectively. In another implementation, a plurality of uneven patterns can be positioned on the surfaces of the first color control pattern 290a, the second color control pattern 290b and the third color control pattern 290c, respectively.

The light emitting display device 200A in accordance with the fourth implementation comprise the plurality of lower uneven patterns 272a, 272b and 272c positioned on the surface of the insulating layer 270a corresponding to the non-emission area NEA, respectively, and the plurality of upper uneven patterns 282a, 282b and 282c positioned on the surface of the first to third black matrices 280a, 280b and 280c, respectively. Accordingly, the amount of external light absorbed by the first to third black matrices 280a, 280b and 280c disposed in the non-emission area NEA can be increased. In addition, it is possible to minimize the reflection of external light caused by the irregular reflections and to maximize the re-absorption of external light.

In addition, the light emitting display device 200A further includes the plurality of light control uneven patterns positioned on the surface of the insulating layer 270A corresponding to the emission area EA. As the external light incident on the color control patterns 290a, 290b and 290c is dispersed, wave guiding can be prevented. Accordingly, it is possible to further minimize the reflection diffraction stains and/or rainbow mura.

Hereinafter, the disclosure is described in more detail by exemplary Examples, but the disclosure is not limited to the Examples below.

### [Example 1] Evaluation of Corrugated Pattern Cross-Section by Photolithography Process Conditions

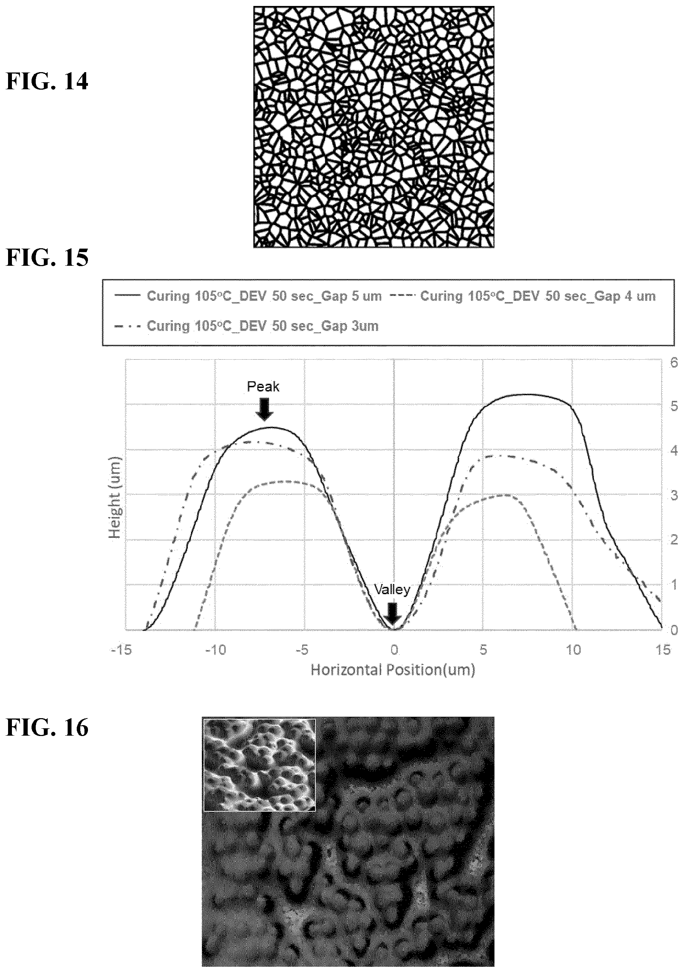

In the photolithography process applying the photomask arrangement illustrated in FIG. 14, the development time was designed to be 50 seconds and the curing temperature was designed to be 105°C, and the Gap between each photomask was designed to be 5 µm, 4 µm, and 3 µm, respectively, and the cross-sectional shape of a number of corrugated or irregular uneven patterns was evaluated by proceeding with the photolithography process. The evaluation result is illustrated in FIG. 15, and the shape of the plurality of corrugated uneven patterns (lower and upper uneven patterns) formed by applying the photomask arrangements structure in FIG. 14 is illustrated in FIG. 16. It was confirmed that the plurality of corrugated uneven patterns intended were implemented even if the gap between the photomasks was different.

### [Example 2] Evaluation of Reflectance of External Light by Corrugated Uneven Patterns

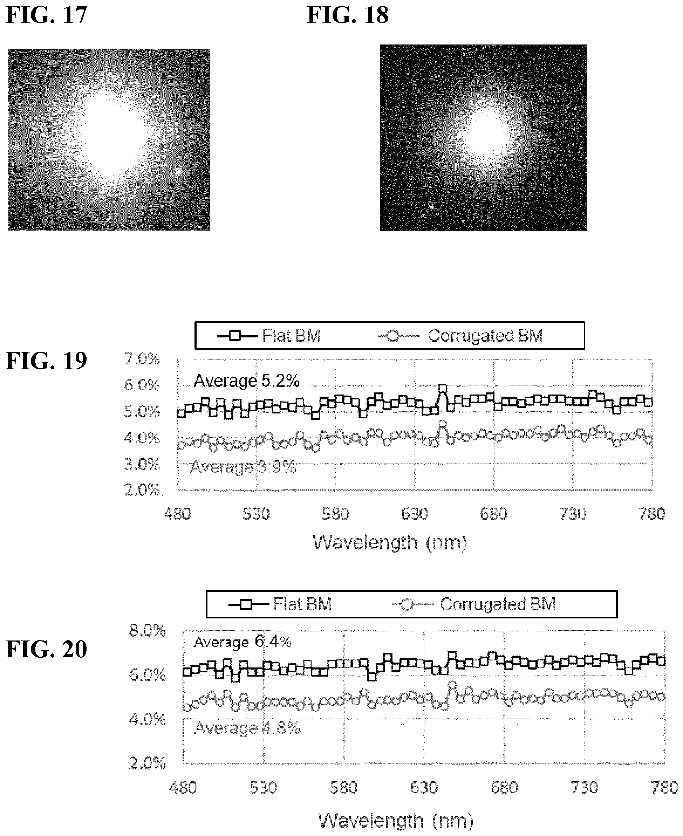

The reflectance of external light and the degree of occurrence of rainbow mura were evaluated when the organic insulating layer and the black matrix (Corrugated BM) having the plurality of corrugated uneven patterns were applied. As a comparative Example, the reflectance of external light and the degree of occurrence of rainbow mura were evaluated when a black matrix (flat BM) with no uneven pattern was applied. As illustrated in FIG. 17, a rainbow mura occurred in the black matrix without the uneven patterns, but as illustrated in FIG. 18, a rainbow mura did not occur in the black matrix with the plurality of corrugated uneven patterns in accordance with the Example.

In addition, as illustrated in FIG. 19 (external light 0 degree incident) and FIG. 20 (external light 45 degrees incident), it was confirmed that the reflectance of external light was significantly reduced in the black matrix with the plurality of corrugated uneven patterns compared to the black matrix without the uneven patterns in the comparative example.

### [Example 3] Evaluation of Relative External Light Reflectance by Pull-Back Length

The relative external light reflectance by the Pull-Back length, which is the distance between the side of the bank layer and the side of black matrix, was evaluated.

The thickness of the encapsulation layer, which is the distance between the upper surface of the planarization layer 134 (FIG. 1) and the lower surface of the black matrix, was designed to be 10 µm, the thickness of the bank layer was designed to be 3 µm, the incident angle of external light was designed to be80°, and the gap between the Corrugated patterns was designed to be 2 µm, and the relative reflectance of external light by the Pull-Back length was evaluated. As a comparative example, a black matrix without the uneven patterns was applied.

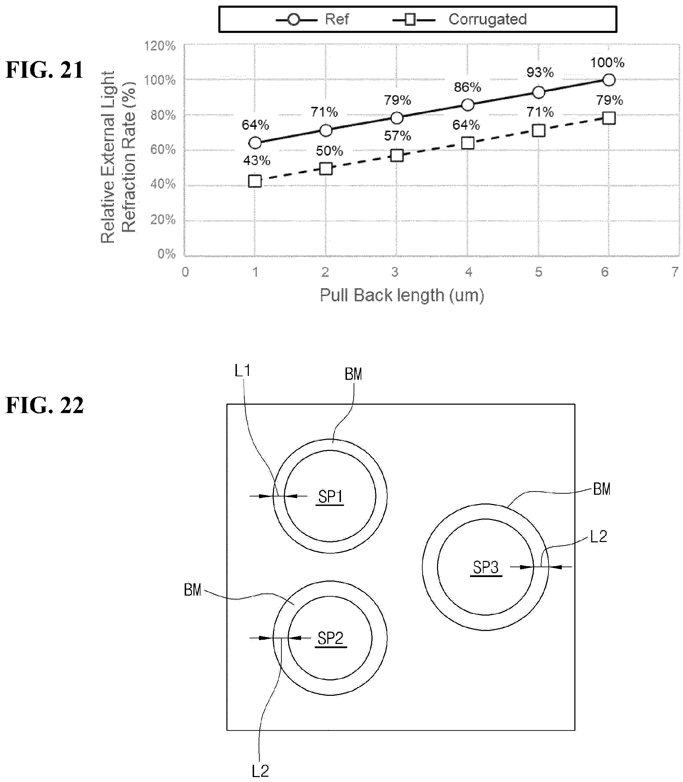

The evaluation result is shown in FIG. 21. In FIG. 21, the circle represents the reflectance of external light in the light emitting display device of the comparative example, and the square represents the reflectance of external light in the light emitting display device having the plurality of uneven patterns according to Example. According to the visibility properties, the reflectance in the green sub-pixel increased by about 30% based on the same Flux. Accordingly, it was confirmed that a differential design of the Pull-Back length is required in the Corrugated black matrix in the red sub-pixel, the green sub-pixel and the blue sub-pixel. For example, when the Pull-Back length is designed to be 4 µm to 7 µm in the red and/or blue sub-pixels and the Pull-Back length is designed to be about 1 µm to 3 µm in the green sub-pixel, it was confirmed that the reflectance of external light can be increased.

FIG. 22 is a schematic plane view of a structure of the first sub-pixel region, the second sub-pixel region and the third sub-pixel region in accordance with an exemplary Example of the disclosure. The Pull-Back structure extension length L1 between the side of the black matrix and the side of the bank layer in the first sub-pixel region of the green (G) sub-pixel, is shorter than the Pull-Back structure extension length L2 between the side of the black matrix and the side of the bank layer in the second sub-pixel region SP2 of the red (R) sub-pixel and the third sub-pixel region SP3 of the blue (B) sub-pixel. The size of the third sub-pixel region SP3, which comprises the blue (B) sub-pixel with relatively low luminous efficiency, is set wider than the sizes of the first sub-pixel region SP1, which comprises the green (G) sub-pixel, and the second sub-pixel region SP2, which comprises the red (R) sub-pixel.

It will be apparent to those skilled in the art that various modifications and variations can be made in the disclosure without departing from the scope of the disclosure. Thus, it is intended that the disclosure cover the modifications and variations of the disclosure provided they come within the scope of the appended claims.

## Claims

1. A light emitting display device, comprising:
a substrate (102) defining an emission area (EA) and a non-emission area (NEA);
a light emitting diode (D) disposed in the emission area (EA) on the substrate (102);
a bank layer (146) disposed in the non-emission area (NEA) at a region outside of the light emitting diode (D);
an insulating layer (170) disposed on the light emitting diode (D) and the bank layer (146);
a color control pattern (190) disposed on the insulating layer (170) to correspond to the emission area (EA); and
a black matrix (180) disposed on the insulating layer (170) to correspond to the non-emission area (NEA),
wherein the insulating layer (170) includes a plurality of lower uneven patterns (172) on a surface of the insulating layer (170) corresponding to the non-emission area (NEA), and/or
the black matrix (180) includes a plurality of upper uneven patterns (182) on a surface of the black matrix (180) corresponding to the non-emission area (NEA).

2. The light emitting display device of claim 1, wherein each of the plurality of lower uneven patterns (172) and the plurality of upper uneven patterns (182) has a corrugated structure, preferably including a plurality of peaks (174a, 184a) and valleys (174b, 184b).

3. The light emitting display device of claim 1 or 2, wherein the color control pattern (190) has a refractive index greater than a refractive index of the insulating layer (170), preferably the color control pattern (190) has a refractive index greater than a refractive index of the insulating layer (170) by an amount between 0.07 and 0.2.

4. The light emitting display device of claim 2 or 3, wherein an angle between a peak and a valley (174a, 184a, 174b, 184b) in the plurality of lower uneven patterns (172) and the plurality of upper uneven patterns (182) is between 15° and 60°.

5. The light emitting display device of claim 2, 3 or 4, wherein the peak (174a) of the plurality of lower uneven patterns (172) is arranged to deviate from or not to overlap with the peak (184a) of the plurality of upper uneven patterns.

6. The light emitting display device of any one of the preceding claims 2-5, wherein a valley (174b) of the lower uneven pattern (172) is arranged to correspond to or to overlap with a peak (184a) of the upper uneven patterns (182), and/or the peak (174a) of the lower uneven patterns (172) is arranged to correspond to or to overlap with a valley (184b) of the upper uneven patterns (182).

7. The light emitting display device of any one of the preceding claims, wherein a side surface of the bank layer (146) is disposed to extend further toward the emission area (EA) than a side surface of the black matrix (180).

8. The light emitting display device of any one of the preceding claims, wherein at least one of the plurality of lower uneven patterns (172) and the plurality of upper uneven patterns (182) extends to a peripheral area of the color control pattern (190).

9. The light emitting display device of any one of the preceding claims, further comprising a plurality of light control uneven patterns (192) formed on the surface of the insulating layer (170) corresponding to the emission area (EA), preferably an average pitch (P1) between adjacent peaks of lower uneven patterns (174a) is smaller than an average pitch (P2) between adjacent peaks (194a) in the light control uneven patterns (192).

10. The light emitting display device of any one of the preceding claims, wherein the substrate (102) comprises a first sub-pixel region (SP1) and a second sub-pixel region (SP2), wherein the color control pattern (190) comprises:
a first color control pattern (290a) in the emission area (EA) in the first sub-pixel region (SP1); and
a second color control pattern (290b) disposed in the emission area in the second sub-pixel region (SP2).

11. The light emitting display device of any one of the preceding claims, wherein the substrate (102) comprises a first sub-pixel region (SP1) and a second sub-pixel region (SP2), the plurality of lower uneven patterns (272a, 272b) comprises:
a plurality of first lower uneven patterns (272a) formed on the surface of the insulating layer (270) corresponding to the non-emission area (NEA) in the first sub-pixel region (SP1); and
a plurality of second lower uneven patterns (272b) formed on the surface of the insulating layer (270) corresponding to the non-emission area (NEA) in the second sub-pixel region (SP2).

12. The light emitting display device of any one of the preceding claims, wherein the substrate (102) comprises a first sub-pixel region (SP1) and a second sub-pixel region (SP2), wherein the black matrix (180) comprises:
a first black matrix (280a) in the non-emission area in the first sub-pixel region (SP1); and
a second black matrix (280b) the non-emission area in the second sub-pixel region (SP2), and/or the plurality of upper uneven patterns (282a, 282b) comprises:
a plurality of first upper uneven patterns (282a) formed on a surface of the first black matrix (280a); and
a plurality of second upper uneven patterns (282b) formed on a surface of the second black matrix 8280b).

13. The light emitting display device of claim 10, 11 or 12, wherein each of the plurality of first lower uneven patterns (272a) and the plurality of first upper uneven patterns (282a) extends to a peripheral area of the first color control pattern (290a), and wherein each of the plurality of second lower uneven patterns (272b) and the plurality of second upper uneven patterns (282b) extends to a peripheral area of the second color control pattern (290b), preferably an extension length of the plurality of first lower uneven patterns (272a) and the plurality of first upper uneven patterns (282a) to the peripheral area of the first color control pattern (290a) is longer than an extension length of the plurality of second lower uneven patterns (72b) and the plurality of second upper uneven patterns (282b) to the peripheral area of the second color control pattern (290b).

14. The light emitting display device of any one of the preceding claims 10-13, wherein the substrate (102) further comprises a third sub-pixel region (SP3), wherein the color control pattern (290) further comprises a third color control pattern (290c) disposed to correspond to the emission area (EA) in the third sub-pixel region (SP3), and the black matrix (280) further comprises a third black matrix (280c) disposed to correspond to the non-emission area (NEA) in the third sub-pixel region (SP3).

15. The light emitting display device of any one of the preceding claims, wherein the first sub-pixel region (SP1) comprises a green sub-pixel, the second sub-pixel region (SP2) comprises a red sub-pixel and the third sub-pixel region (SP3) comprises a blue sub-pixel, preferably a voltage applied to the first sub-pixel region (SP1) is greater than a voltage applied to each of the second sub-pixel region (SP2) and the third sub-pixel region (SP3).
